# EUROPÄISCHE PATENTSCHRIFT

(11) **EP 0 388 615 B1**
(45) Veröffentlichungstag und Bekanntmachung des Hinweises auf die Patenterteilung: **18.05.1994**
(21) Anmeldenummer: 90102250.9
(22) Anmeldetag: 05.02.1990
(51) Int. Cl.: H03M 7/00, H03M 5/12

(54) **CMI-Decodier- und Taktrückgewinnungseinrichtung**
CMI decoder and clock frequency recovery
Dispositif de récupération de cycle et de décodage CMI

(30) Priorität: 02.03.1989 DE 3906696
(43) Veröffentlichungstag der Anmeldung: 26.09.1990
(73) Patentinhaber: SIEMENS AKTIENGESELLSCHAFT, 80333 München (DE)
(72) Erfinder: Eilken, Jens-Peter, Dipl.-Ing.(FH), D-8000 München 71 (DE); Gasser, Kurt, D-8032 Gräfelfing (DE); Pfriem, Horst-Ludwig, Dipl.-Ing., D-8000 München 71 (DE)

(56) Entgegenhaltungen:
- DE-A- 2 929 248
- DE-A- 3 310 713
- DE-A- 3 625 589
- DE-A- 3 723 187
- JP-A-63 263 846
- Patent abstract of Japan, unexamined applications, E Field, Band 11, nr.367, 28 November 1987

## Beschreibung

Die Erfindung bezieht sich auf eine CMI-Decodier- und Taktrückgewinnungseinrichtung.

Beim CMI-Code (Coded Mark Inversion) wird der Binärwert "1" abwechselnd durch einen positiven und einen negativen Zustand und der Binärwert "0", unabhängig vom vorhergegangenen Bit, durch einen negativen Zustand in der ersten Hälfte und einen positiven in der zweiten Hälfte des Bitintervalls dargestellt.

Aus der Siemens-Gebrauchsunterlage Bestell. Nr. S42024-D3702-C1-2-70, Februar 1987, ist ein Einschub 140-Mbit/s-Schnittstelle E bekannt, der einen CMI-Decoder und eine Taktrückgewinnungseinrichtung enthält.

In der deutschen Offenlegungsschrift DE-A 29 29 248 ist ein CMI-Decoder nach dem Oberbegriff des Anspruchs 1 beschrieben.

Die spektrale Energieverteilung eines CMI-codierten Datensignals hängt stark von der Bitfolge ab. Bei einer Dauer-"1" (AIS) enthält dieses Signal keine Energie bei der Taktfrequenz. Erst durch eine Veränderung des Datensignals in einer Schaltung zur Taktrückgewinnung wird die spektrale Energieverteilung so geändert, daß bei allen möglichen Bitfolgen Energieanteile bei der Taktfrequenz auftreten. In der genannten Schnittstelle wird dies dadurch erreicht, daß das invertierte und das um ein halbes Bit verzögerte Datensignal einem UND-Gatter zugeführt wird. An dessen Ausgang entsteht ein Signal, das einen auf die Taktfrequenz abgestimmten Schwingkreis anregt. Das ausgesiebte Taktsignal wird durch einen Verstärker soweit verstärkt, daß die nachfolgende Schaltung unter allen Betriebsbedingungen einen ausreichenden Taktpegel erhält. Durch eine Phasenschiebeschaltung wird die Taktphase zum Datenbit passend abgeglichen.

Aus der DE-A 36 25 589 ist ebenfalls eine derartige Taktrückgewinnungsschaltung bekannt.

Diese Taktrückgewinnungseinrichtung en haben folgende Nachteile: Der Schwingkreis muß wegen großer Taktpausen eine bestimmte Mindestgüte haben. Zur Verstärkung des Taktsignals ist deswegen ein separater Verstärker notwendig. Die Taktrückgewinnung hat eine große Durchlaufzeit und damit eine von den Bauteile-Toleranzen abhängige große absolute Laufzeit-Toleranz. Dies erfordert eine separate Schaltung zum Abgleich der Taktphase.

Die Laufzeit des Signals durch die Taktrückgewinnungseinrichtung ist auch von der Betriebsspannung und der Temperatur abhängig. Dies verringert die Jitterverträglichkeit im Betriebsbereich des Gerätes.

Aufgabe der Erfindung ist es, eine CMI-Decodier- und Taktrückgewinnungseinrichtung anzugeben, in der möglichst viele Komponenten integrierbar sind, die keine separate Schaltung für Phasenabgleich und Verstärkung benötigt und die im gesamten Betriebsbereich eine hohe Jitterverträglichkeit aufweist.

Diese Aufgabe wird erfindungsgemäß mit den Merkmalen des Patentanspruchs 1 gelöst. Ausgestaltungen der Erfindung sind den abhängigen Ansprüchen zu entnehmen.

Anhand von Ausführungsbeispielen wird die Erfindung nachstehend näher erläutert.
- Figur 1: zeigt eine CMI-Decodier- und Taktrückgewinnungseinrichtung nach dem Stand der Technik,
- Figur 2: zeigt einen CMI-Decoder nach dem Stand der Technik gemäß DE-A 29 29 248,
- Figur 3: zeigt einen Pulsplan zur Erläuterung des CMI-Decoders nach Figur 2,
- Figur 4: zeigt eine Taktrückgewinnungseinrichtung nach dem Stand der Technik gemäß DE-A 36 25 589,
- Figuren 5 - 7: zeigen Pulspläne zur Erläuterung der Wirkungsweise der Einrichtung nach Figur 4,
- Figur 8: zeigt eine erfindungsgemäße Taktrückgewinnungseinrichtung,
- Figuren 9 - 11: zeigen Pulspläne zur Erläuterung der Einrichtung nach Figur 8,
- Figur 12: zeigt eine erfindungsgemäße CMI-Decodier- und Taktrückgewinnungseinrichtung und
- Figur 13: zeigt eine Taktfrequenz-Selektionseinrichtung.

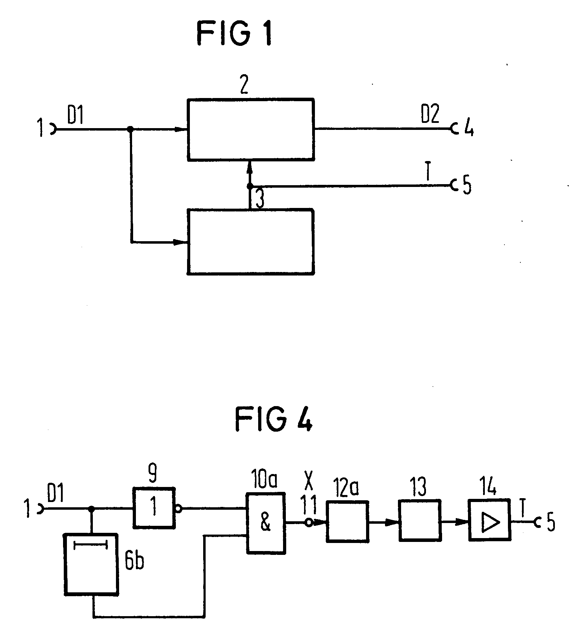

Figur 1 zeigt ein Blockschaltbild einer CMI-Decodier- und Taktrückgewinnungseinrichtung nach dem Stand der Technik mit einem CMI-Decoder 2 und einer Taktrückgewinnungseinrichtung 3. Über den Dateneingang 1 wird ein CMI-codiertes Datensignal D1 zugeführt; am Datenausgang 4 wird ein binäres Datensignal D2 und am Ausgang 5 wird ein rückgewonnener Takt T abgenommen.

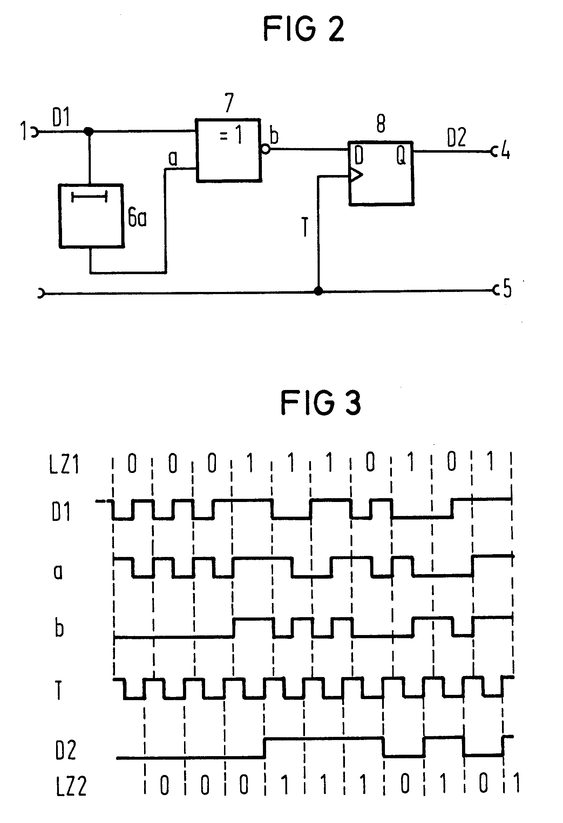

Figur 2 zeigt einen CMI-Decoder nach dem Stand der Technik mit einem um ein halbes Bit verzögernden Laufzeitglied 6a, ein Exklusiv-NOR-Gatter 7 und ein flankengetriggertes D-Flipflop 8.

Figur 3 zeigt ein am Dateneingang 1 anliegendes CMI-codiertes Datensignal D1 und die zugehörigen logischen Zustände LZ1, ein um ein halbes Bit verzögertes Datensignal am Schaltungspunkt a, ein Ausgangssignal des Exklusiv-NOR-Gatters 7 am Schaltungspunkt b, den Takt T und das binäre Datensignal D2 am Ausgang 4 mit den logischen Zuständen LZ2 als Ergebnis der Decodierung.

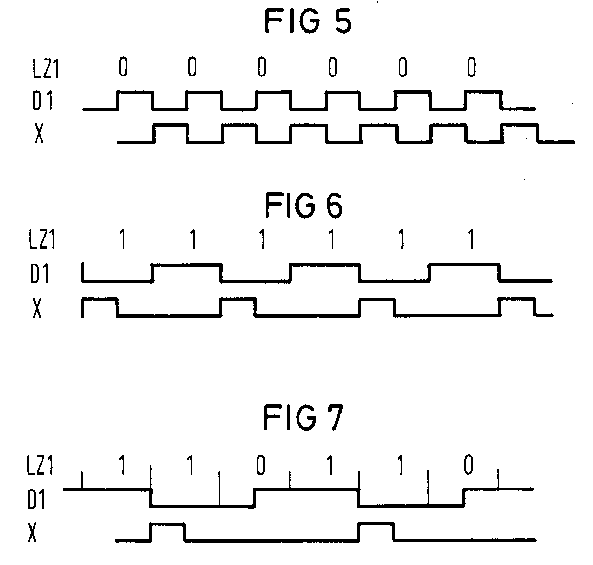

Figur 4 zeigt eine Taktrückgewinnungseinrichtung nach dem Stand der Technik mit einem um ein halbes Bit verzögernden Laufzeitglied 6b, mit einem Inverter 9, mit einem UND-Gatter 10a, mit einem Anschluß 11, mit einer Taktfrequenz-Selektionseinrichtung 12a, mit einem Phasenschieber 13 und mit einem Verstärker 14.

Die Figuren 5 bis 7 zeigen Pulsdiagramme mit dem Datensignal D1 und einem Signal X am Anschluß 11 für Bitfolgen "000", "111" und "110". Figur 5 zeigt die für die Taktrückgewinnung günstigste, Figur 6 eine mittelgünstige und Figur 7 die ungünstigste Bitfolge. Aus diesen Beispielen ist die starke Abhängigkeit des Signals X von der Bitfolge ersichtlich. Diese muß einerseits durch die Güte der Taktfrequenz-Selektionseinrichtung 12a und andererseits durch die Verstärkung des Verstärkers 14 kompensiert werden.

Ersteres bedeutet ein Überdecken der Taktpausen, letzteres einen Ausgleich der Amplituden-Unterschiede.

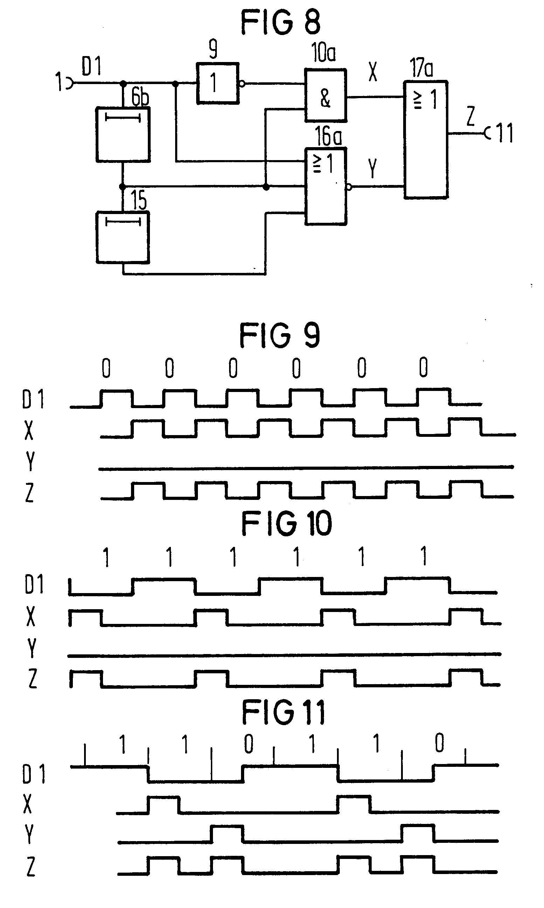

Figur 8 zeigt eine erfindungsgemäße Taktrückgewinnungseinrichtung. Diese enthält aus der Figur 4 bekannte Elemente wie das Laufzeitglied 6b, den Inverter 9 und das UND-Gatter 10a. Zusätzlich ist ein zweites, um ein halbes Bit verzögerndes Laufzeitglied 15, ein NOR-Gatter 16a und ein ODER-Gatter 17a enthalten.

In der Taktrückgewinnungseinrichtung nach Figur 8 wird wie bei der nach Figur 4 ein Signal X gewonnen. Mit Hilfe des Laufzeitgliedes 15 und des NOR-Gatters 16a erhält man ein weiteres Signal Y, das phasenrichtig zum Signal X halbbitbreite Impulse liefert, die, mit dem Signal X im ODER-Gatter 17a verknüpft, ein Signal Z ergeben.

Die Figuren 9 bis 11 zeigen zur Taktrückgewinnungseinrichtung nach Figur 8 Pulsdiagramme für die Bitfolgen "000", "111" und "110". Es ist erkennbar, daß insbesondere gegenüber der ungünstigsten Bitfolge "110" in Figur 7 das Signal Z jetzt doppelt so viele Impulse zur Anregung der Taktfrequenz-Selektionseinrichtung 12a enthält.

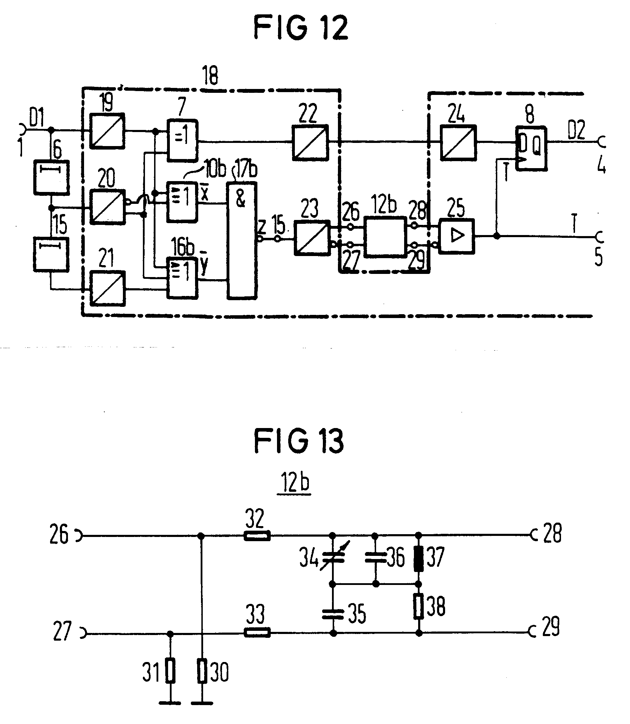

Figur 12 zeigt eine vollständige erfindungsgemäße CMI-Decodier- und Taktrückgewinnungseinrichtung. Bis auf Laufzeitglieder 6 und 15 und eine Taktfrequenz-Selektionseinrichtung 12b sind alle Elemente in einer integrierten Schaltung 18 (ECL-Gate Array) untergebracht. Eingangspegelwandler 19, 20, 21 und 24 sowie ein Differenz-Eingangspegelwandler 25 setzen ECL-Signale auf einen internen Pegel (E2CL) für die integrierte Schaltung 18 um. Vor einer Signalabgabe aus der integrierten Schaltung 18 wird dieser Pegel durch Ausgangspegelwandler 22 und 23 rückumgesetzt. Rechts außen in Fig. 12 ist die integrierte Schaltung 18 nicht vollständig dargestellt, da sie dort noch weitere nicht zur Erfindung gehörenden Schaltungsteile enthält.

Die in der integrierten Schaltung 18 enthaltene Taktrückgewinnungseinrichtung unterscheidet sich von der nach Figur 4 dadurch, daß anstelle des UND-Gatters 10a ein ODER-Gatter b, anstelle des NOR-Gatters 16a ein ODER-Gatter 16b und statt des ODER-Gatters 17a ein NAND-Gatter 17b vorgesehen ist. Die wirkungsweise beider unterscheidet sich nur in den logischen Zuständen auf den Verbindungsleitungen. In beiden Fällen wird ein Signal Z erzeugt.

Da die Taktfrequenz-Selektionseinrichtung 12b außerhalb der integrierten Schaltung 18 angeordnet ist, benötigt sie ein Ausgangspegelwandler 23 und ein Differenz-Eingangspegelwandler 25. Damit die Laufzeit auf dem Wege des Taktes T nicht länger ist als die auf dem Wege des Datensignals, sind in diesem ebenfalls ein Ausgangspegelwandler 22, ein äußerer Weg und ein Eingangspegelwandler 24 vorgesehen. Änderung durch Fertigungssteuerung bei der Herstellung der integrierten Schaltungen, Temperatur- und Betriebsspannungsabweichungen betreffen damit beide Signale in gleicher Weise und beeinflussen nicht den Abtaktzeitpunkt am D-Flipflop 8. Somit bleibt die Jitterverträglichkeit von diesen Änderungen unbeeinflußt.

Die Selektionseinrichtung 12b hat 90° Phasenverschiebung. Wenn sie auf die Taktfrequenz abgestimmt wird, ergibt dies auch den zum Abtakten des Datensignals optimalen Zeitpunkt.

Der Phasenschieber 13 kann entfallen, weil die erfindungsgemäße Schaltung so ausgelegt ist, das Takt und Daten am D-Flipflop 8 unabhängig von Bauteiletoleranzen immer phasenrichtig anliegen. Der Verstärker 14 kann entfallen, weil das durch die erfindungsgemäße Schaltung gewonnene Signal Z auch bei der ungünstigsten Bitfolge nur um 6dB gedämpft wird. Diese Dämpfung kann der Eingangspegelwandler 25 ausgleichen.

Figur 13 zeigt eine mögliche Realisierung der Taktfrequenz-Selektionseinrichtung 12b mit Widerständen 30 bis 33 und 38, Kondensatoren 34 bis 36 und einer Spule 37. Diese und die Kondensatoren 34 - 36 bilden den eigentlichen Schwingkreis, der mit dem Kondensator 34 auf die Taktfrequenz abgestimmt wird. Die Widerstände 32 und 33 bestimmen die Güte, und die Widerstände 30 und 31 bilden einen Abschlußwiderstand für den Emitterausgang der ECL-integrierten-Schaltung. Der Kondensator 35 ist für die Parallelresonanz des Schwingkreises ohne Bedeutung.

Der Offset des Differenz-Eingangspegelwandlers 25 ist typisch null. Er neigt ohne definierte Eingangsspannung zu Eigenschwingungen. Dieser undefinierte Zustand wird durch die Parallelschaltung des Kondensator 35 und des Widerstandes 38 vermieden.

Fällt das Datensignal D1 aus, bleibt das Signal am Eingang 26 auf logisch "H" und das Signal am Eingang 27 auf logisch "L". Über die Widerstände 32 bzw. 33 und 38 erhält der Differenz-Eingangspegelwandler 25 am Eingang eine kleine Spannungsdifferenz, sodaß sein Ausgang, also der rückgewonnene Takt T auch ohne anliegendes Datensignal D1 einen eindeutigen logischen Zustand "H" oder "L" annimmt.

## Patentansprüche

1. CMI-Decodier- (2) und Taktrückgewinnungseinrichtung (3) mit einem Exklusiv-NOR-Gatter (7), dessen erster Eingang unmittelbar und dessen zweiter Eingang über ein erstes, um ein halbes Bit verzögerndes Laufzeitglied (6,6a,6b) mit einem Dateneingang (1) verbunden ist,
mit einem D-Flipflop (8), dessen Eingang mit dem Ausgang des Exklusiv-NOR-Gatters (7) und dessen Q̅-Ausgang mit einem Datenausgang (4) verbunden ist, und
mit einer Taktfrequenz-Selektionseinrichtung (12a,12b), deren Ausgang mit dem Takteingang des D-Flipflops (8) verbunden ist,
**dadurch gekennzeichnet**,
daß ein zweites, um ein halbes Bit verzögerndes Laufzeitglied (15) vorgesehen ist, dessen Eingang mit dem Ausgang des ersten Laufzeitgliedes (6, 6a, 6b) verbunden ist,
daß ein UND-Gatter (10a) vorgesehen ist, dessen erster invertierender Eingang mit dem Dateneingang (1) und dessen zweiter Eingang mit dem Ausgang des ersten Laufzeitgliedes (6,6a,6b) verbunden ist, und
daß ein NOR-Gatter (16a) vorgesehen ist, dessen erster Eingang mit dem Dateneingang (1), dessen zweiter Eingang mit dem Ausgang des ersten Laufzeitgliedes (6,6a,6b) und dessen dritter Eingang mit dem Ausgang des zweiten Laufzeitgliedes (15) verbunden ist, daß ein ODER-Gatter (17a) vorgesehen ist, dessen erster Eingang mit dem Ausgang des UND-Gatters (10a) und dessen zweiter Eingang mit dem Ausgang des NOR-Gatters (16a) verbunden ist, und daß der Eingang der Taktfrequenz-Selektionseinrichtung (12a, 12b) mit dem Ausgang des ODER-Gatters (17a) verbunden ist.

2. CMI-Decodier- (2) und Taktrückgewinnungseinrichtung (3) nach Anspruch 1,
**dadurch gekennzeichnet**,
daß die Gatter (7,9,10a,10b,16a,16b,17a,17b) und das D-Flipflop (8) als integrierte Schaltung (18), z.B. als ECL-Gate Array, vorgesehen sind und
daß an jedem Eingang der integrierten Schaltung (18) ein Eingangspegelwandler (19,20,21,24,25) und an jedem Ausgang der integrierten Schaltung (18) ein Ausgangspegelwandler (22,23) vorgesehen ist.

3. CMI-Decodier- (2) und Taktrückgewinnungseinrichtung (3) nach einem der Ansprüche 1 oder 2,
**dadurch gekennzeichnet**,
daß die Taktfrequenz-Selektionseinrichtung (12a,12b)
einen ersten Widerstand (30) zwischen ihrem ersten Eingang (26) und Erde,
einen zweiten Widerstand (31) zwischen ihrem zweiten Eingang (27) und Erde,
einen dritten Widerstand (32), der mit einem ersten Anschluß mit dem ersten Eingang (26) verbunden ist,
einen vierten Widerstand (33), der mit einem ersten Anschluß mit dem zweiten Eingang (27) verbunden ist, und
eine Reihenschaltung enthält, die aus einer ersten Parallelschaltung mit einem einstellbaren Kondensator (34), mit einem ersten Festkondensator (36) und mit einer Induktivität (37) und aus einer zweiten Parallelschaltung mit einem zweiten Festkondensator (35) und einem fünften Widerstand (38) besteht, und bei der der äußere Anschluß der ersten Parallelschaltung mit dem zweiten Anschluß des dritten Widerstandes (32) und einem ersten Ausgang (28) und der äußere Anschluß der zweiten Parallelschaltung mit dem zweiten Anschluß des vierten Widerstandes (33) und einem zweiten Ausgang (29) verbunden ist.

## Claims

1. CMI decoding (2) and clock recovery device (3) having an exclusive-NOR gate (7), the first input of which is connected directly to a data input (1) and the second input of which is connected to the said data input via a first delay element (6, 6a, 6b), delaying by half a bit, having a delay flipflop (8), the input of which is connected to the output of the exclusive-NOR gate (7) and the Q̅ output of which is connected to a data output (4), and having a clock frequency selection device (12a, 12b), the output of which is connected to the clock input of the delay flipflop (8), characterized in that a second delay element (15), delaying by half a bit, is provided, the input of which is connected to the output of the first delay element (6, 6a, 6b), in that an AND gate (10a) is provided, the first inverting input of which is connected to the data input (1) and the second input of which is connected to the output of the first delay element (6, 6a, 6b), and in that a NOR gate (16a) is provided, the first input of which is connected to the data input (1), the second input of which is connected to the output of the first delay element (6, 6a, 6b) and the third input of which is connected to the output of the second delay element (15), in that an OR gate (17a) is provided, the first input of which is connected to the output of the AND gate (10a) and the second input of which is connected to the output of the NOR gate (16a), and in that the input of the clock frequency selection device (12a, 12b) is connected to the output of the OR gate (17a).

2. CMI decoding (2) and clock recovery device (3) according to Claim 1, characterized in that the gates (7, 9, 10a, 10b, 16a, 16b, 17a, 17b) and the delay flipflop (8) are provided as an integrated circuit (18), for example as an ECL gate array, and in that at each input of the integrated circuit (18) there is provided an input level converter (19, 20, 21, 24, 25) and at each output of the integrated circuit (18) there is provided an output level converter (22, 23).

3. CMI decoding (2) and clock recovery device (3) according to one of Claims 1 or 2, characterized in that the clock frequency selection device (12a, 12b) includes a first resistor (30) between its first input (26) and earth, a second resistor (31) between its second input (27) and earth, a third resistor (22), which is connected by a first terminal to the first input (26), a fourth resistor (33), which is connected by a first terminal to the second input (27), and a series connection, which comprises a first parallel connection with a variable capacitor (34), with a first fixed capacitor (36) and with an inductance (37) and comprises a second parallel connection with a second fixed capacitor (35) and a fifth resistor (38), and in which device the outer terminal of the first parallel connection is connected to the second terminal of the third resistor (32) and to a first output (28) and the outer terminal of the second parallel connection is connected to the second terminal of the fourth resistor (33) and to a second output (29).

## Revendications

1. Dispositif de décodage CMI (2) et de récupération de la cadence (3), comportant une porte NON-OU-Exclusif (7), dont la première entrée est reliée directement à une entrée de données (1) et dont la deuxième entrée est reliée, par l'intermédiaire d'un premier circuit à retard (6, 6a, 6b) retardant d'un demi-bit, à une entrée de données (1),
comportant un multivibrateur bistable-D (8), dont l'entrée est reliée à la sortie de la porte NON-OU-Exclusif (7) et dont la sortie Q̅ est reliée à une sortie de données (4), et
comportant un dispositif de sélection de fréquence de cadence (12a, 12b) dont la sortie est reliée à l'entrée de cadence du multivibrateur bistable-D (8),
caractérisé en ce
qu'il est prévu un deuxième circuit à retard (15) qui retarde d'un demi-bit et dont l'entrée est reliée à la sortie du premier circuit à retard (6, 6a, 6b),
qu'il est prévu une porte ET (10a), dont la première entrée inverseuse est reliée à l'entrée de données (1) et dont la deuxième entrée est reliée à la sortie du premier circuit à retard (6,6a,6b), et
qu'il est prévu une porte NON-OU (16a), dont la première entrée est reliée à l'entrée de données (1), dont la deuxième entrée est reliée à la sortie du premier circuit à retard (6,6a,6b) et dont la troisième entrée est reliée à la sortie du deuxième circuit à retard (15),
qu'il est prévu une porte OU (17a), dont la première entrée est reliée à la sortie de la porte ET (10a) et dont la deuxième entrée est reliée à la sortie de la porte NON-OU (16a), et
que l'entrée du dispositif de sélection de fréquence de la cadence (12a, 12b) est reliée à la sortie de la porte OU (17a).

2. Dispositif de décodage CMI (2) et de récupération de la cadence (3) suivant la revendication 1,
caractérisé en ce
que les portes (7,9,10a,10b,16a,16b,17a,17b) et le multivibrateur bistable-D (8) sont prévus en tant que circuit intégré (18), par exemple en tant que circuit prédiffusé en logique ECL, et
qu'il est prévu, à chaque entrée du circuit intégré (18), un transducteur de niveau d'entrée (19,20,21,24,25) et à chaque sortie du circuit intégré (18), un transducteur de niveau de sortie (22,23).

3. Dispositif de décodage CMI (2) et de récupération de la cadence (3) suivant l'une des revendications 1 ou 2,
caractérisé en ce
que le dispositif de sélection de fréquence de la cadence (12a, 12b) comporte
une première résistance (30) entre sa première entrée (26) et la masse,
une deuxième résistance (31) entre sa deuxième entrée (27) et la masse,
une troisième résistance (32), qui est reliée par une première borne à la première entrée (26),
une quatrième résistance qui est reliée par une première borne à la deuxième entrée (27), et
un circuit série qui est constitué d'un premier circuit parallèle comportant un condensateur réglable (34), un premier condensateur fixe (36) et une inductance (37), et d'un deuxième circuit parallèle comportant un deuxième condensateur fixe (35) et une cinquième résistance (38), et dans lequel la borne extérieure du premier circuit parallèle est reliée à la deuxième borne de la troisième résistance (32) et à une première sortie (28), et la borne extérieure du deuxième circuit parallèle est reliée à la deuxième borne de la quatrième résistance (33) et à une deuxième sortie (29).
